# EUROPEAN PATENT APPLICATION

(11) **EP 4 800 757 A1**
(43) Date of publication of application: **02.09.2026**
(21) Application number: 24882960.8
(22) Date of filing: 28.10.2024
(51) Int. Cl.: H01M 4/36, H01M 4/525, H01M 4/505, C30B 29/22, C30B 1/02, H01M 4/131, C01G 53/00, H01M 10/052, H01M 4/02

(54) **CATHODE ACTIVE MATERIAL FOR LITHIUM SECONDARY BATTERY, MANUFACTURING METHOD THEREOF AND LITHIUM SECONDARY BATTERY COMPRISING SAME**

(30) Priority: 26.10.2023 KR 20230145045
(71) Applicant: POSCO Holdings Inc., Pohang-si, Gyeongsangbuk-do 37859 (KR)
(72) Inventor: YU, Byongyong, Pohang-si, Gyeongsangbuk-do 37859 (KR); SONG, Jun-Hyuk, Pohang-si, Gyeongsangbuk-do 37859 (KR); CHOI, Geunho, Pohang-si, Gyeongsangbuk-do 37859 (KR); NAM, Sang Cheol, Pohang-si, Gyeongsangbuk-do 37859 (KR); PARK, Inchul, Pohang-si, Gyeongsangbuk-do 37859 (KR); CHOI, Sol, Pohang-si, Gyeongsangbuk-do 37859 (KR); KIM, Jieun, Pohang-si, Gyeongsangbuk-do 37859 (KR)
(74) Representative: Pfenning, Meinig & Partner mbB
(86) International application number: PCT/KR2024/096402
(87) International publication number: WO 2025/089934

(57) **Abstract**

The present invention relates to a positive electrode active material for a lithium secondary battery, comprising a single-particle lithium metal oxide and a cobalt-containing coating layer disposed on a surface of the lithium metal oxide, wherein the coating layer is in an island-type including a plurality of attachment particles that are attached to the surface of the lithium metal oxide and are spaced apart from each other, and an average coverage rate of the coating layer is 35 to 48 area% based on a total surface area of the single particle.

## Description

### [Technical Field]

The present invention relates to a positive electrode active material for a lithium secondary battery, a method for preparing the same, and a lithium secondary battery comprising the same.

### [Background Art]

Lithium cobalt oxide (LiCoO₂), lithium nickel oxide (LiNiO₂), lithium manganese oxide (such as LiMnO₂ or LiMn₂O₄), and lithium iron phosphate compounds (LiFePO₄) have been used as positive electrode active materials for lithium secondary batteries. Among these, lithium cobalt oxide is advantageous in terms of high operating voltage and excellent capacity characteristics, but it is difficult to commercially apply to large-capacity batteries due to the high price and unstable supply of cobalt, which is the raw material. Lithium nickel oxide has poor structural stability, making it difficult to realize sufficient lifespan characteristics. On the other hand, lithium manganese oxide has excellent stability but suffers from poor capacity characteristics.

To compensate for the problems of lithium transition metal oxides containing Ni, Co, or Mn alone, lithium composite transition metal oxides containing two or more types of transition metals have been developed. Among these, lithium nickel cobalt manganese oxide containing Ni, Co, and Mn is widely used in the field of electric vehicle batteries.

Conventional lithium nickel cobalt manganese oxide is generally in the form of spherical secondary particles in which tens to hundreds of primary particles are aggregated. However, in the case of lithium nickel cobalt manganese oxide in the form of secondary particles where many primary particles are aggregated as described above, particle cracking, in which primary particles fall off during the rolling process in the manufacture of the positive electrode, is likely to occur, and cracks occur inside the particles during the charging and discharging process. When particle cracking or cracks of the positive electrode active material occur, the contact area with the electrolyte increases, leading to increased gas generation and degradation of the active material due to side reactions with the electrolyte, which results in a problem of deteriorated lifespan characteristics.

Furthermore, recently, demand for high-output, high-capacity batteries such as batteries for electric vehicles has been increasing, and accordingly, the nickel content in positive electrode active materials is gradually increasing. When the nickel content in the positive electrode active material increases, initial capacity characteristics are improved; however, as charging and discharging are repeated, a large amount of highly reactive Ni⁴⁺ ions are generated, causing structural collapse of the positive electrode active material. This increases the degradation rate of the positive electrode active material, leading to deteriorated lifespan characteristics and reduced battery safety.

To solve the above problem, a technique for preparing a positive electrode active material in the form of single particles rather than secondary particles by increasing the calcination temperature during the preparation of lithium nickel cobalt manganese oxide has been proposed. In the case of a single-particle positive electrode active material, compared to a conventional secondary-particle positive electrode active material, side reactions with the electrolyte are fewer because the contact area with the electrolyte is smaller, and particle cracking during electrode manufacturing is reduced due to excellent particle strength. Therefore, the application of a single-particle positive electrode active material has the advantages of reduced gas generation and excellent lifespan characteristics.

However, single-particle positive electrode active material particles have relatively large primary particle sizes compared to conventional secondary-particle positive electrode active material particles and fewer interfaces between primary particles that serve as diffusion paths for lithium ions, resulting in poor lithium mobility. Furthermore, because they are manufactured at relatively high calcination temperatures, a rocksalt-phase is formed on the particle surface, resulting in high surface resistance. This decrease in lithium mobility primarily reduces capacity characteristics and secondarily causes an imbalance in lithium ion movement, leading to crystal structure deformation and particle cracking, which results in a problem of deteriorated lifespan characteristics, such as an increase in resistance as cycles progress.

### [DETAILED DESCRIPTION OF THE INVENTION]

### [Technical Problem]

Accordingly, an object of the present invention is to provide a single-particle positive electrode active material for a lithium secondary battery having excellent capacity characteristics and a low resistance increase rate as cycles progress, a method for preparing the same, and a lithium secondary battery comprising the same.

### [Technical Solution]

One embodiment of the present invention provides a positive electrode active material for a lithium secondary battery, comprising: a single-particle lithium metal oxide; and a coating layer containing cobalt disposed on a surface of the lithium metal oxide, wherein the coating layer is in an island-type including a plurality of attachment particles that are attached to the surface of the lithium metal oxide and are spaced apart from each other, and an average coverage rate of the coating layer is 35 to 48 area% based on a total surface area of the single particle.

An average diameter of the attachment particles may be 160 to 240 nm.

An average thickness of the attachment particles may be 50 to 90 nm.

A content of cobalt in the coating layer may be 0.7 to 4.8 mol% based on a total number of moles of the lithium metal oxide.

In XPS analysis at an outermost surface portion of the lithium metal oxide, a first peak may appear in a binding energy region of 775 to 785 eV, and a full width at half maximum (FWHM) of the first peak may be 2.5 eV or less.

In XPS analysis at the outermost surface portion of the lithium metal oxide, a second peak may appear in a binding energy region of 790 to 800 eV, and a full width at half maximum (FWHM) of the second peak may be 2.5 eV or less.

In XPS analysis at a depth of 100 nm from the outermost surface of the lithium metal oxide, a third peak may appear in a binding energy region of 775 to 785 eV, and a full width at half maximum (FWHM) of the third peak may be 4 eV or less.

In XPS analysis at a depth of 100 nm from the outermost surface of the lithium metal oxide, a fourth peak may appear in a binding energy region of 790 to 800 eV, and a full width at half maximum (FWHM) of the fourth peak may be 4 eV or less.

The coating layer may comprise CoO, Co₃O₄, LiCoO₂, or a combination thereof.

An average aspect ratio of the attachment particles may be 1.5 or less.

The lithium metal oxide and the coating layer may have a layered crystal structure.

The lithium metal oxide may be represented by Chemical Formula 1 below:

[Chemical Formula 1] Liₐ[NiₓCo_{y}Mn_{z}M_{w}]O₂

In Chemical Formula 1, 0.8≤a≤1.3, 0.15≤x≤1, 0≤y≤1, 0≤z≤1, 0≤w≤0.1, x+y+z+w≤1, and M is Zr, Al, B, Y, Mg, Ti, Nb, W, Sc, Si, V, Fe, Y, Mo, Ce, Hf, Ta, La, Sr, Re, Cr, Ga, Pt, or a combination thereof. Another embodiment of the present invention provides a method for preparing a positive electrode active material for a lithium secondary battery, the method comprising: preparing a metal precursor; mixing the metal precursor with a first lithium raw material and calcining the mixture to form a single-particle lithium metal oxide; and mixing the lithium metal oxide with a cobalt raw material and performing a coating heat treatment to form a cobalt-containing coating layer, wherein the coating layer is in an island-type including a plurality of attachment particles that are attached to a surface of the lithium metal oxide and are spaced apart from each other, and an average coverage rate of the coating layer is 35 to 48 area% based on a total surface area of the single particle.

In the forming of the coating layer, the cobalt raw material may be added in an amount of 0.7 to 4.8 mol% based on a total number of moles of the lithium metal oxide.

In the forming of the coating layer, the coating heat treatment may be performed at a temperature of 620 to 700°C.

The cobalt raw material may have a sphericity of 0.8 or more.

In the forming of the coating layer, a second lithium raw material may be further mixed.

An added amount of the second lithium raw material may be 4 mol% or less based on the total number of moles of the lithium metal oxide.

The cobalt raw material may be Co(OH)₂, CoCl₂, CoO, CoF₃, CoSO₄·xH₂O, CoSO₄·7H₂O, (CH₃COO)₂Co·4H₂O, Co(NO₃)₂·6H₂O, (CH₃CO₂)₂Co, CoCO₃·xH₂O, Co₃(PO₄)₂, or a combination thereof.

A water washing process may not be performed after the forming of the lithium metal oxide and before the forming of the coating layer. Another embodiment of the present invention provides a positive electrode for a lithium secondary battery comprising the aforementioned positive electrode active material.

Another embodiment of the present invention provides a lithium secondary battery comprising the positive electrode for a lithium secondary battery.

### [Advantageous Effects]

The positive electrode active material for a lithium secondary battery according to an embodiment of the present invention is a single-particle lithium metal oxide that contains an island-type cobalt-containing coating layer. By appropriately controlling the structure of the coating layer, capacity characteristics can be excellent and the resistance increase rate as cycles progress can be low.

### [Brief Description of Drawings]

FIGS. 1 and 2 are SEM images of a positive electrode active material prepared according to Example 2.
FIG. 3 shows TEM and SAED pattern analysis images of a positive electrode active material prepared according to Example 2.
FIG. 4 is a graph of XPS analysis results for a positive electrode active material prepared according to Example 2.
FIG. 5 is a graph of XPS analysis results for a positive electrode active material prepared according to Comparative Example 1.

### [Best Mode]

Terms such as first, second, and third are used to describe various parts, components, regions, layers, and/or sections, but are not limited thereto. These terms are used only to distinguish one part, component, region, layer, or section from another part, component, region, layer, or section. Accordingly, a first part, component, region, layer, or section described below may be referred to as a second part, component, region, layer, or section without departing from the scope of the present invention.

The terminology used herein is only for the purpose of referring to specific embodiments and is not intended to limit the present invention. As used herein, the singular forms include the plural forms as well unless the context clearly indicates otherwise. The meaning of "comprising" as used in the specification specifies a particular characteristic, region, integer, step, operation, element, and/or component, and does not exclude the presence or addition of other characteristics, regions, integers, steps, operations, elements, and/or components.

When a part is referred to as being "above" or "on" another part, it may be directly above or on the other part, or another part may be involved in between. In contrast, when a part is referred to as being "directly above" another part, no other part is interposed therebetween.

Unless defined otherwise, all terms including technical and scientific terms used herein have the same meaning as generally understood by one of ordinary skill in the art to which the present invention belongs. Commonly used terms defined in a dictionary are further interpreted to have meanings consistent with relevant technical literature and the presently disclosed content, and are not interpreted in an ideal or very formal sense unless defined otherwise.

In addition, unless otherwise specified, % means weight %, and 1 ppm is 0.0001 weight %.

In the present specification, the term "combination(s) thereof" described in the Markush type expression means one or more mixtures or combinations selected from the group consisting of components described in the Markush type expression, and means including any one or more selected from the group consisting of the components.

Hereinafter, embodiments of the present invention will be described in detail so that those skilled in the art to which the present invention belongs can easily implement them. However, the present invention may be implemented in many different forms and is not limited to the embodiments described herein.

### 1. Positive Electrode Active Material

A positive electrode active material for a lithium secondary battery according to an embodiment of the present invention comprises a single-particle lithium metal oxide. A single-particle positive electrode active material has a smaller specific surface area than existing general secondary particles, so the amount of gas generated by side reactions with an electrolyte is reduced, particle strength is high so that particle cracking during rolling can be suppressed, and the occurrence of cracks due to repeated charging and discharging can be reduced. Accordingly, it has advantages in that lifespan and safety are superior to secondary particles, and high energy density of an electrode can be realized.

In the present specification, "single particle" is a term used to distinguish from secondary-particle positive electrode active material particles formed by aggregation of tens to hundreds of primary particles commonly used in the past, and is a concept including a single particle consisting of one primary particle and an aggregate particle of 30 or fewer primary particles. In addition, "secondary particle" refers to an aggregate, i.e., a secondary structure, in which tens to hundreds of primary particles are aggregated by physical or chemical bonding between primary particles without an intentional aggregation or assembly process for the primary particles.

However, single-particle positive electrode active material particles have relatively large primary particle sizes compared to conventional secondary-particle positive electrode active material particles and fewer interfaces between primary particles that serve as diffusion paths for lithium ions, resulting in poor lithium mobility. Furthermore, because they are manufactured at relatively high calcination temperatures, a rocksalt-phase is formed on the particle surface, resulting in high surface resistance. This decrease in lithium mobility primarily reduces capacity characteristics and secondarily causes an imbalance in lithium ion movement, leading to crystal structure deformation and particle cracking, which results in a problem of deteriorated lifespan characteristics, such as an increase in resistance as cycles progress.

Accordingly, the positive electrode active material for a lithium secondary battery according to an embodiment of the present invention comprises a coating layer containing cobalt disposed on a surface of the lithium metal oxide. In this case, the coating layer is in an island-type including a plurality of attachment particles that are attached to the surface of the lithium metal oxide and are spaced apart from each other. By the positive electrode active material according to the present invention comprising an island-type cobalt-containing coating layer, capacity is improved and the resistance increase rate as cycles progress can be reduced. In the past, a conformal coating layer covering the entire surface of a lithium metal oxide was often formed to improve the electrochemical characteristics of an active material. However, to realize a conformal coating layer, a high-temperature coating heat treatment process or the like is required, which results in high process costs, and it is difficult to realize good thickness uniformity, causing a problem of increased resistance. In contrast, as the positive electrode active material according to the present invention comprises an island-type coating layer, process costs can be reduced. In addition, it becomes possible to implement an island-type coating layer including unit attachment particles of uniform size and thickness, thereby improving capacity and reducing the resistance increase rate as cycles progress.

Meanwhile, in the present specification, "attachment particles" refer to units attached to the surface of the lithium metal oxide when the surface of the lithium metal oxide is observed through a scanning electron microscope (SEM), and mean the minimum particle units that are spaced apart from each other and distinguished as a single lump.

The form of the attachment particles is amorphous and is not particularly limited, but more specifically, they may have a dot shape with an average aspect ratio of 1.5 or less. In the present specification, "aspect ratio" means a ratio of a longest side length to a shortest side length in an attachment particle, and "average aspect ratio" can be obtained by deriving an average value for 20 arbitrary attachment particles observed on an SEM image at 30,000x magnification.

At this time, the lithium metal oxide and the coating layer may have a layered crystal structure. That is, in the positive electrode active material according to the present invention, not only the lithium metal oxide, which is a bulk portion, but also the coating layer may have a layered crystal structure. As both the bulk portion and the coating layer have a layered crystal structure, the diffusivity of lithium ions in the layered structure can be maintained in both the bulk portion and the coating layer, so the aforementioned electrochemical characteristic improvement effect can be more preferably realized.

In addition, the average coverage rate of the coating layer may be 35 to 48 area%, and more specifically 38 to 46 area%, based on the total surface area of the single particle of the lithium metal oxide. If the average coverage rate of the coating layer is too large, surface inactive resistance of the active material increases, and characteristics such as capacity and the resistance increase rate as cycles progress may deteriorate. If the average coverage rate of the coating layer is too small, the residual lithium removal rate is low and surface cation mixing increases, so that characteristics such as capacity and the resistance increase rate as cycles progress may deteriorate. In the present specification, the coverage rate of the coating layer may mean a ratio of an area where a plurality of attachment particles cover the surface of the lithium metal oxide. The average coverage rate of such a coating layer can be measured by the following method. First, the coverage rate of a coating layer for one positive electrode active material particle can be obtained as a percentage value of the total area of attachment particles with respect to the total surface area of the lithium metal oxide particle seen when observing the surface of the lithium metal oxide with a 30,000x magnification SEM. In addition, the average coverage rate of the coating layer can be derived by obtaining the coverage rate for each of 20 arbitrary positive electrode active material particles in the positive electrode active material powder by the above method and calculating their average value.

In addition, the average diameter of the attachment particles may be 160 to 240 nm, and more specifically 170 to 230 nm. If the average diameter of the attachment particles is too small, the coating effect such as surface protection is inferior, and characteristics such as capacity and the resistance increase rate as cycles progress may deteriorate. If the average diameter of the attachment particles is too large, surface inactive resistance of the active material increases, and characteristics such as capacity and the resistance increase rate as cycles progress may deteriorate. In the present specification, the diameter of an attachment particle may mean the longest side length in the attachment particle. The average diameter of such attachment particles can be derived by calculating the average value of the longest side lengths for 20 arbitrary attachment particles seen when observing the positive electrode active material with a 30,000x magnification SEM.

In addition, the average thickness of the attachment particles may be 50 to 90 nm, and more specifically 55 to 85 nm. If the average thickness of the attachment particles is too small, the coating effect such as surface protection is inferior, and characteristics such as capacity and the resistance increase rate as cycles progress may deteriorate. If the average thickness of the attachment particles is too large, surface inactive resistance of the active material increases, and characteristics such as capacity and the resistance increase rate as cycles progress may deteriorate. In the present specification, the thickness of an attachment particle may mean the height of the attachment particle when the surface of the lithium metal oxide is used as a base plane. The average thickness of such attachment particles can be measured by the following method. First, the thickness of attachment particles for one positive electrode active material particle can be derived by measuring the thickness of arbitrary attachment particles seen when observing a cross-section of the positive electrode active material particle with a 500,000x magnification TEM (transmission electron microscope). Next, the average thickness of the attachment particles can be obtained by deriving the thickness of the attachment particles for each of 20 arbitrary positive electrode active material particles in the positive electrode active material powder by the above method and then deriving their average value.

The content of cobalt in the coating layer may be 0.7 to 4.8 mol%, and more specifically 0.8 to 4 mol%, based on the total number of moles of the lithium metal oxide. When the content of cobalt in the coating layer satisfies the above range, the average coverage rate of the coating layer, the average particle diameter of the attachment particles, and the average thickness of the attachment particles can be more easily obtained within the ranges according to the present invention.

At this time, the coating layer may comprise CoO, Co₃O₄, LiCoO₂, or a combination thereof. CoO, Co₃O₄, or LiCoO₂ has good structural and phase stability characteristics, so the aforementioned electrochemical characteristic improvement effect can be more preferably realized. The presence of CoO, Co₃O₄, or LiCoO₂ can be confirmed through XPS analysis of the outermost surface portion of the lithium metal oxide, as described later.

In addition, in XPS analysis at the outermost surface portion of the lithium metal oxide, a first peak may appear in a binding energy region of 775 to 785 eV. At this time, the full width at half maximum (FWHM) of the first peak may be 2.5 eV or less, and more specifically 2.4 eV or less. The first peak in the above region may mean Co 2p3/2. As the FWHM of the first peak satisfies the above range, CoO, Co₃O₄, or LiCoO₂ crystal phases with good electrochemical activity are well formed, so the aforementioned electrochemical characteristic improvement effect can be more preferably realized. Meanwhile, in the present specification, XPS means X-ray Photoelectron Spectroscopy.

In addition, in XPS analysis at the outermost surface portion of the lithium metal oxide, a second peak may appear in a binding energy region of 790 to 800 eV. At this time, the FWHM of the second peak may be 2.5 eV or less, and more specifically 2.4 eV or less. The second peak in the above region may mean Co 2p1/2. As the FWHM of the second peak satisfies the above range, CoO, Co₃O₄, or LiCoO₂ crystal phases with good electrochemical activity are well formed, so the aforementioned electrochemical characteristic improvement effect can be more preferably realized.

In addition, in XPS analysis at a depth of 100 nm from the outermost surface of the lithium metal oxide, a third peak may appear in a binding energy region of 775 to 785 eV. At this time, the FWHM of the third peak may be 4 eV or less, and more specifically 3.5 eV or less. The third peak in the above region may mean Co 2p3/2. As the FWHM of the third peak satisfies the above range, CoO, Co₃O₄, or LiCoO₂ crystal phases with good electrochemical activity are well formed, so the aforementioned electrochemical characteristic improvement effect can be more preferably realized.

In XPS analysis at a depth of 100 nm from the outermost surface of the lithium metal oxide, a fourth peak may appear in a binding energy region of 790 to 800 eV. At this time, the FWHM of the fourth peak may be 4 eV or less, and more specifically 3.5 eV or less. The fourth peak in the above region may mean Co 2p1/2. As the FWHM of the fourth peak satisfies the above range, CoO, Co₃O₄, or LiCoO₂ crystal phases with good electrochemical activity are well formed, so the aforementioned electrochemical characteristic improvement effect can be more preferably realized.

In addition, the lithium metal oxide according to the present invention may have a residual lithium content of 5,000 ppm or less, and more specifically 4,500 ppm, 4,000 ppm, 3,500 ppm, or 3,200 ppm or less. The present inventors confirmed that when physical properties such as the average coverage rate of the coating layer are adjusted within the range according to the present invention, the residual lithium content is significantly reduced. Residual lithium generates gas by side reactions with the electrolyte, which can cause a decrease in safety and lifespan characteristics of the battery. Therefore, safety and lifespan characteristics of the lithium metal oxide according to the present invention can be improved by the residual lithium content satisfying the above range.

More specifically, the lithium metal oxide may be represented by Chemical Formula 1 below:

[Chemical Formula 1] Liₐ[NiₓCo_{y}Mn_{z}M_{w}]O₂

In Chemical Formula 1, 0.8≤a≤1.3, 0.15≤x≤1, 0≤y≤1, 0≤z≤1, 0≤w≤0.1, x+y+z+w≤1, and M is Zr, Al, B, Y, Mg, Ti, Nb, W, Sc, Si, V, Fe, Y, Mo, Ce, Hf, Ta, La, Sr, Re, Cr, Ga, Pt, or a combination thereof.

### 2. Method for Preparing Positive Electrode Active Material

Another embodiment of the present invention provides a method for preparing a positive electrode active material for a lithium secondary battery, the method comprising: preparing a metal precursor; mixing the metal precursor with a first lithium raw material and calcining the mixture to form a single-particle lithium metal oxide; and mixing the lithium metal oxide with a cobalt raw material and performing a coating heat treatment to form a cobalt-containing coating layer, wherein the coating layer is in an island-type including a plurality of attachment particles that are attached to a surface of the lithium metal oxide and are spaced apart from each other, and an average coverage rate of the coating layer is 35 to 48 area% based on a total surface area of the single particle.

Hereinafter, the method for preparing a positive electrode active material for a lithium secondary battery according to another embodiment of the present invention will be described step by step. First, a metal precursor is prepared. More specifically, the metal precursor may be a metal hydroxide. The metal precursor may be prepared, for example, by adding a complexing agent-containing solution and a pH adjusting agent-containing solution to a metal-containing solution including a nickel raw material, a manganese raw material, or a cobalt raw material to perform a coprecipitation reaction.

The nickel raw material is not particularly limited as long as it is used in the preparation of a positive electrode active material precursor in the art. For example, the nickel raw material may be a nickel-containing sulfate, acetate, nitrate, halide, sulfide, hydroxide, oxide, or oxyhydroxide, and specifically NiSO₄, NiSO₄·6H₂O, Ni(OH)₂, NiO, NiOOH, NiCO₃·2Ni(OH)₂·4H₂O, NiC₂O₂·2H₂O, Ni(NO₃)₂·6H₂O, nickel fatty acid salts, nickel halides, or a combination thereof, but is not limited thereto.

The cobalt raw material is not particularly limited as long as it is used in the preparation of a positive electrode active material precursor in the art. For example, the cobalt raw material may be a cobalt-containing sulfate, acetate, nitrate, halide, sulfide, hydroxide, oxide, or oxyhydroxide, and specifically CoSO₄, CoSO₄·7H₂O, Co(OH)₂, CoOOH, Co(OCOCH₃)₂·4H₂O, Co(NO₃)₂·6H₂O, or a combination thereof, but is not limited thereto.

The manganese raw material is not particularly limited as long as it is used in the preparation of a positive electrode active material precursor in the art. For example, the manganese raw material may be a manganese-containing sulfate, acetate, nitrate, halide, sulfide, hydroxide, oxide, oxyhydroxide, or a combination thereof, and specifically MnSO₄, MnCO₃, Mn(NO₃)₂, manganese salts such as manganese acetate, manganese dicarboxylate, manganese citrate, and manganese fatty acid salts, manganese oxides such as Mn₂O₃, MnO₂, and Mn₃O₄, oxyhydroxides, manganese chloride, or a combination thereof, but is not limited thereto.

The metal-containing solution may be prepared by adding a nickel raw material, a manganese raw material, or a cobalt raw material to a solvent, specifically water, or a mixture of water and an organic solvent (e.g., alcohol, etc.) that can be uniformly mixed with water.

The complexing agent-containing solution performs a complex formation role and may include, for example, NH₃, NH₄OH, (NH₄)₂SO₄, NH₄NO₃, NH₄Cl, CH₃COONH₄, NH₄CO₃, or a combination thereof as a complexing agent, but is not limited thereto. Meanwhile, the complexing agent-containing solution may be used in the form of an aqueous solution, and in this case, water or a mixture of water and an organic solvent (e.g., alcohol, etc.) uniformly miscible with water may be used as the solvent.

The pH adjusting agent-containing solution performs a role as a precipitant or pH adjuster, and may include alkaline compounds of hydroxides of alkali metals or alkaline earth metals such as NaOH, KOH, or Ca(OH)₂, hydrates thereof, or combinations thereof. Meanwhile, the pH adjusting agent-containing solution may also be used in the form of an aqueous solution, and in this case, water or a mixture of water and an organic solvent (e.g., alcohol, etc.) uniformly miscible with water may be used as the solvent. At this time, the pH adjusting agent-containing solution may be added in an amount such that the pH of the reaction solution becomes 10 to 13.

The coprecipitation reaction may be performed under an inert atmosphere such as nitrogen or argon, and may be performed at a temperature of 30 to 70°C and at pH 10 to 13.

Particles of nickel (-or manganese-cobalt) hydroxide are produced by the above process and are precipitated in the reaction solution. The precipitated precursor particles are separated according to a conventional method, washed with water, and dried to obtain a precursor. The precursor may be a secondary particle formed by aggregation of primary particles.

At this time, by adjusting the concentrations of the nickel raw material, the cobalt raw material, or the manganese raw material, the molar ratio of nickel, cobalt, or manganese in the precursor can be adjusted. That is, the concentrations of the nickel raw material, the cobalt raw material, and the manganese raw material can be adjusted so that the molar ratio of nickel, cobalt, or manganese in the lithium metal oxide, which is the final product, is within the range according to the present invention. Next, the metal precursor and the first lithium raw material are mixed and then calcined to form a single-particle lithium metal oxide. At this time, lithium-containing sulfate, nitrate, acetate, carbonate, oxalate, citrate, halide, hydroxide, or oxyhydroxide may be used as the first lithium raw material, and it is not particularly limited as long as it is soluble in water. Specifically, the lithium raw material may be Li₂CO₃, LiNO₃, LiNO₂, LiOH, LiOH·H₂O, LiH, LiF, LiCl, LiBr, LiI, CH₃COOLi, Li₂O, Li₂SO₄, CH₃COOLi, Li₃C₆H₅O₇, or a combination thereof, but is not limited thereto.

In addition, the calcination may be performed at a temperature of 800 to 1,000°C. If the calcination temperature is too low, the single-particle lithium metal oxide may not be formed. If the calcination temperature is too high, crystal structure defects may occur due to over-calcination, leading to poor electrochemical characteristics.

In addition, the calcination may be performed for 5 to 20 hours. If the calcination time is too short, the single-particle lithium metal oxide may not be formed. If the calcination time is too long, crystal structure defects may occur due to over-calcination, leading to poor electrochemical characteristics.

In addition, the atmosphere during the calcination is not particularly limited, but may be performed, for example, in an oxygen (O₂) or air atmosphere. At this time, a water washing process may not be performed after the forming of the lithium metal oxide and before the forming of the coating layer. The water washing process is usually performed to remove residual lithium remaining on the surface of the synthesized lithium metal oxide. However, in the present invention, residual lithium remaining immediately after synthesis is reacted with a cobalt raw material, described later, through a coating heat treatment to form a layered coating layer based on a lithium cobalt oxide composition with good electrochemical activity, and the average coverage rate of the coating layer can be well realized within the range according to the present invention. Next, the lithium metal oxide and the cobalt raw material are mixed and then coating heat treated to form a cobalt-containing coating layer. At this time, the cobalt raw material may be added in an amount of 0.7 to 4.8 mol% based on the total number of moles of the lithium metal oxide. When the content of the cobalt raw material satisfies the above range, the content of raw materials for forming the coating layer is appropriately adjusted, so that physical properties such as the average coverage rate of the coating layer can be more easily obtained within the range according to the present invention.

In addition, the coating heat treatment may be performed at a temperature of 620 to 700°C, and more specifically at a temperature of 640 to 690°C. If the coating heat treatment temperature is too low, the formation of the coating layer does not occur sufficiently, so the average coverage rate of the coating layer and the average diameter or thickness of the attachment particles may be obtained too small. If the coating heat treatment temperature is too high, a conformal-type coating layer rather than an island-type may be formed.

In addition, the cobalt raw material may have a sphericity of 0.8 or more, and more specifically 0.85 or 0.9 or more. If the sphericity of the cobalt raw material is too small, the average coverage rate of the coating layer is obtained too small, and the average diameter or average thickness of the coating layer may be obtained too large. Meanwhile, in the present specification, sphericity is a numerical expression of the degree to which a particle is close to a sphere, and refers to a value obtained by dividing the circumference of a circle having the same area as the projected shape of the particle by the actual circumference of the projected shape of the particle through a flow-type particle analyzer. Such sphericity can be measured using an analyzer for obtaining an optical image (Fluid Imaging Technologies, Flowcam 8100) and analysis software (visual spreadsheet).

In addition, in the forming of the coating layer, a second lithium raw material may be further mixed. By further mixing the second lithium raw material, the formation of a layered coating layer based on a lithium cobalt oxide composition with good electrochemical activity can be well achieved, and physical properties such as the average coverage rate of the coating layer can be better implemented within the range according to the present invention.

In addition, at this time, the added amount of the second lithium raw material may be 4 mol% or less, and more specifically 3.5 mol% or 3 mol% or less, based on the total number of moles of the lithium metal oxide. If the added amount of the second lithium raw material is too large, physical properties such as the average coverage rate of the coating layer may deviate from the range according to the present invention.

The cobalt raw material may be Co(OH)₂, CoCl₂, CoO, CoF₃, CoSO₄·xH₂O, CoSO₄·7H₂O, (CH₃COO)₂Co·4H₂O, Co(NO₃)₂·6H₂O, (CH₃CO₂)₂Co, CoCO₃·xH₂O, Co₃(PO₄)₂, or a combination thereof, but is not necessarily limited thereto.

Through this, the coating layer according to the present invention having the aforementioned structure can be well formed.

### 3. Positive Electrode and Lithium Secondary Battery

Another embodiment of the present invention provides a positive electrode for a lithium secondary battery comprising the aforementioned positive electrode active material. More specifically, the positive electrode may comprise a positive electrode current collector and a positive electrode active material layer disposed on the positive electrode current collector and comprising the aforementioned positive electrode active material.

The positive electrode current collector is not particularly limited as long as it possesses conductivity without causing chemical changes in the battery. For example, stainless steel, aluminum, nickel, titanium, sintered carbon, or surface-treated aluminum or stainless steel with carbon, nickel, titanium, silver, etc., may be used. In addition, the positive electrode current collector typically may have a thickness of 3 to 500 µm, and fine irregularities may be formed on the surface of the positive electrode current collector to increase the adhesion of the positive electrode active material. For example, it may be used in various forms such as films, sheets, foils, nets, porous bodies, foams, non-woven fabrics, and the like.

The positive electrode active material layer may include a binder and/or a conductive material along with the aforementioned positive electrode active material.

At this time, the binder serves to improve adhesion between positive electrode active material particles and adhesion between the positive electrode active material and the positive electrode current collector. Specific examples include polyvinylidene fluoride (PVDF), vinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, polytetrafluoroethylene, polyethylene, polypropylene, ethylene-propylene-diene monomer rubber (EPDM rubber), sulfonated EPDM, styrene-butadiene rubber (SBR), fluororubber, or various copolymers thereof, and one type alone or a mixture of two or more types thereof may be used, but is not limited thereto. The binder may be included in an amount of 1 to 30% by weight based on the total weight of the positive electrode active material layer.

And, the conductive material is used to impart conductivity to the electrode and can be used without particular limitation as long as it possesses electronic conductivity without causing chemical changes in the configured battery. Specific examples include graphite such as natural graphite or artificial graphite; carbon-based materials such as carbon black, acetylene black, ketjen black, channel black, furnace black, lamp black, thermal black, and carbon fibers; metal powders or metal fibers such as copper, nickel, aluminum, and silver; conductive whiskers such as zinc oxide and potassium titanate; conductive metal oxides such as titanium oxide; or conductive polymers such as polyphenylene derivatives, and one type alone or a mixture of two or more types thereof may be used, but is not limited thereto. The conductive material typically may be included in an amount of 1 to 30% by weight based on the total weight of the positive electrode active material layer.

The positive electrode can be manufactured according to a conventional positive electrode manufacturing method, except for using the positive electrode active material described above.

Specifically, the positive electrode can be manufactured by applying a composition for forming a positive electrode active material layer, which includes the aforementioned positive electrode active material and optionally a binder, conductive material, or solvent, onto the positive electrode current collector, followed by drying and rolling. At this time, the types and contents of the positive electrode active material, binder, and conductive material are as described above.

The solvent may be a solvent commonly used in the art, such as dimethyl sulfoxide (DMSO), isopropyl alcohol, N-methylpyrrolidone (NMP), acetone, or water, and one type alone or a mixture of two or more types thereof may be used. The amount of the solvent used is sufficient as long as it dissolves or disperses the positive electrode active material, conductive material, and binder considering the coating thickness of the slurry and manufacturing yield, and has a viscosity that can exhibit excellent thickness uniformity during subsequent coating for positive electrode manufacturing.

As another method, the positive electrode may be manufactured by casting the composition for forming the positive electrode active material layer onto a separate support and then laminating a film obtained by peeling it from the support onto the positive electrode current collector. Another embodiment of the present invention provides a lithium secondary battery comprising the aforementioned positive electrode for a lithium secondary battery. More specifically, the lithium secondary battery may comprise a positive electrode; a negative electrode; a separator; and an electrolyte.

The lithium secondary battery may optionally further comprise a battery container for housing an electrode assembly of the positive electrode, the negative electrode, and the separator, and a sealing member for sealing the battery container.

The negative electrode may comprise a negative electrode current collector and a negative electrode active material layer positioned on the negative electrode current collector.

The negative electrode current collector is not particularly limited as long as it possesses high conductivity without causing chemical changes in the battery. For example, copper, stainless steel, aluminum, nickel, titanium, sintered carbon, or surface-treated copper or stainless steel with carbon, nickel, titanium, silver, etc., an aluminum-cadmium alloy, and the like may be used. In addition, the negative electrode current collector typically may have a thickness of 3 to 500 µm, and similar to the positive electrode current collector, fine irregularities may be formed on the surface of the current collector to enhance the binding force of the negative electrode active material. For example, it may be used in various forms such as films, sheets, foils, nets, porous bodies, foams, non-woven fabrics, and the like.

The negative electrode active material layer optionally may comprise a binder and a conductive material along with a negative electrode active material. As an example, the negative electrode active material layer may be manufactured by applying a composition for forming a negative electrode active material layer including a negative electrode active material and optionally a binder and a conductive material onto a negative electrode current collector and drying, or by casting the negative electrode forming composition onto a separate support and then laminating a film obtained by peeling it from the support onto the negative electrode current collector.

As the negative electrode active material, a compound capable of reversible intercalation and deintercalation of lithium may be used. Specific examples include carbonaceous materials such as artificial graphite, natural graphite, graphitized carbon fiber, and amorphous carbon; metallic compounds capable of alloying with lithium such as Si, Al, Sn, Pb, Zn, Bi, In, Mg, Ga, Cd, Si alloys, Sn alloys, or Al alloys; metal oxides capable of doping and dedoping lithium such as SiOβ (0 < β < 2), SnO₂, vanadium oxide, and lithium vanadium oxide; or composites comprising the metallic compound and the carbonaceous material such as Si-C composites or Sn-C composites, and any one or a mixture of two or more thereof may be used. In addition, a metallic lithium thin film may be used as the negative electrode active material. Further, as the carbon material, both low-crystalline carbon and high-crystalline carbon may be used. Representative low-crystalline carbons include soft carbon and hard carbon, and representative high-crystalline carbons include high-temperature calcined carbons such as natural graphite or artificial graphite in amorphous, plate-like, flake-like, spherical, or fibrous form, Kish graphite, pyrolytic carbon, mesophase pitch based carbon fiber, meso-carbon microbeads, mesophase pitches, and petroleum or coal tar pitch derived cokes.

The binder and the conductive material may be the same as those described above for the positive electrode. The separator separates the negative electrode and the positive electrode and provides a passage for lithium ions. Any separator typically used in lithium secondary batteries can be used without particular limitation, and particularly one having low resistance to ion movement of the electrolyte and excellent electrolyte impregnation ability is preferable. Specifically, a porous polymer film, for example, a porous polymer film manufactured from a polyolefin-based polymer such as ethylene homopolymer, propylene homopolymer, ethylene/butene copolymer, ethylene/hexene copolymer, and ethylene/methacrylate copolymer, or a stacked structure of two or more layers thereof may be used. In addition, a conventional porous non-woven fabric, for example, a non-woven fabric made of high-melting point glass fiber, polyethylene terephthalate fiber, or the like may be used. Further, a coated separator containing a ceramic component or a polymer material may be used to secure heat resistance or mechanical strength, and optionally a single-layer or multi-layer structure may be used. The electrolyte may include an organic liquid electrolyte, an inorganic liquid electrolyte, a solid polymer electrolyte, a gel polymer electrolyte, a solid inorganic electrolyte, a molten inorganic electrolyte, etc., which can be used in the manufacture of lithium secondary batteries, but is not limited thereto.

Specifically, the organic liquid electrolyte may include an organic solvent and a lithium salt.

The organic solvent can be used without particular limitation as long as it can serve as a medium through which ions involved in the electrochemical reaction of the battery can move. Specifically, as the organic solvent, ester-based solvents such as methyl acetate, ethyl acetate, γ-butyrolactone, and ε-caprolactone; ether-based solvents such as dibutyl ether or tetrahydrofuran; ketone-based solvents such as cyclohexanone; aromatic hydrocarbon-based solvents such as benzene and fluorobenzene; carbonate-based solvents such as dimethyl carbonate (DMC), diethyl carbonate (DEC), methylethyl carbonate (MEC), ethylmethyl carbonate (EMC), ethylene carbonate (EC), and propylene carbonate (PC); alcohol-based solvents such as ethyl alcohol and isopropyl alcohol; nitriles such as R-CN (where R is a C2 to C20 linear, branched, or cyclic hydrocarbon group, and may include a double bond, an aromatic ring, or an ether bond); amides such as dimethylformamide; dioxolanes such as 1,3-dioxolane; or sulfolanes may be used. Among these, carbonate-based solvents are preferable, and a mixture of a cyclic carbonate (e.g., ethylene carbonate or propylene carbonate, etc.) having high ionic conductivity and high dielectric constant that can increase charge/discharge performance of the battery and a low-viscosity linear carbonate-based compound (e.g., ethylmethyl carbonate, dimethyl carbonate, or diethyl carbonate, etc.) is more preferable. In this case, better electrolyte performance can be exhibited when the cyclic carbonate and the chain carbonate are mixed in a volume ratio of about 1:1 to about 1:9.

The lithium salt can be used without particular limitation as long as it is a compound capable of providing lithium ions used in a lithium secondary battery. Specifically, as the lithium salt, LiPF₆, LiClO₄, LiAsF₆, LiBF₄, LiSbF₆, LiAlO₄, LiAlCl₄, LiCF₃SO₃, LiC₄F₉SO₃, LiN(C₂F₅SO₃)₂, LiN(C₂F₅SO₂)₂, LiN(CF₃SO₂)₂, LiCl, LiI, LiB(C₂O₄)₂, or the like may be used. It is preferable to use the concentration of the lithium salt within a range of 0.1 to 2.0 M. When the concentration of the lithium salt is within the above range, the electrolyte has appropriate conductivity and viscosity, so that excellent electrolyte performance can be exhibited and lithium ions can effectively move.

In addition to the electrolyte components, the electrolyte may further include one or more additives for the purpose of improving lifespan characteristics of the battery, suppressing a decrease in battery capacity, improving discharge capacity of the battery, and the like, for example, haloalkylene carbonate-based compounds such as difluoroethylene carbonate, pyridine, triethylphosphite, triethanolamine, cyclic ethers, ethylenediamine, n-glyme, hexamethylphosphoric triamide, nitrobenzene derivatives, sulfur, quinone imine dyes, N-substituted oxazolidinones, N,N-substituted imidazolidines, ethylene glycol dialkyl ethers, ammonium salts, pyrrole, 2-methoxyethanol, or aluminum trichloride. At this time, the additive may be included in an amount of 0.1 to 5% by weight based on the total weight of the electrolyte.

As described above, since the lithium secondary battery comprising the positive electrode active material according to the present invention stably exhibits excellent discharge capacity, output characteristics, and capacity retention rate, it is useful in the field of portable devices such as mobile phones, notebook computers, and digital cameras, and electric vehicles such as hybrid electric vehicles (HEVs).

Accordingly, another embodiment of the present invention provides a battery module including the lithium secondary battery as a unit cell and a battery pack including the same.

The battery module or battery pack can be used as a power source for one or more medium-to-large sized devices among power tools; electric vehicles including Electric Vehicles (EVs), Hybrid Electric Vehicles, and Plug-in Hybrid Electric Vehicles (PHEVs); or power storage systems. Hereinafter, embodiments of the present invention will be described in more detail through examples. However, the following examples are only one preferred embodiment of the present invention, and the present invention is not limited by the following examples.

### Example 1

### (1) Preparation of Positive Electrode Active Material

(Preparation of Metal Precursor) First, a metal precursor having a composition of Ni₀.₈₉Co₀.₀₃₇Mn₀.₀₇₃(OH)₂ was prepared.

(Calcination) Thereafter, the metal precursor and LiOH·H₂O as a first lithium raw material were mixed and then calcined in an oxygen atmosphere at a temperature of 860°C for 10 hours to form a single-particle lithium metal oxide. At this time, a separate water washing process was not performed after the formation of the lithium metal oxide.

(Coating Heat Treatment) Thereafter, the lithium metal oxide, Co(OH)₂ having a sphericity of 0.9 as a ground cobalt raw material, and LiOH·H₂O as a second lithium raw material were mixed and then coating heat treated at a temperature of 680°C to form a coating layer. At this time, the added amount of Co(OH)₂ was 1.0 mol% based on the total number of moles of the lithium metal oxide, and the added amount of the second lithium raw material was 1.0 mol% based on the total number of moles of the lithium metal oxide.

### (2) Manufacture of Lithium Secondary Battery

The slurry for manufacturing an electrode plate was mixed in a weight ratio of the prepared positive electrode active material : conductive material (carbon black, Denka Black) : binder (PVDF, KF1100) = 92.5 : 3.5 : 4 wt%, and NMP (N-Methyl-2-pyrrolidone) was added to adjust the viscosity such that the solid content was about 30%. The prepared slurry was coated onto a 15 µm thick Al foil using a doctor blade and then dried and rolled. The electrode loading was 14.6 mg/cm², and the rolling density (25°C, 20 kN) was 3.1 g/cm³.

The electrolyte used was 1M LiPF₆ in EC:DMC:EMC=3:4:3 (vol%) with 3.0 vol% of VC added based on the total amount of the electrolyte. A coin cell was manufactured using a PP separator and a lithium negative electrode (200 µm, Honzo Metal).

### Example 2

A positive electrode active material and a lithium secondary battery were manufactured in the same manner as in Example 1, except that in the coating heat treatment step, the added amount of Co(OH)₂ was 2.0 mol% based on the total number of moles of the lithium metal oxide, and the added amount of the second lithium raw material was 2.0 mol% based on the total number of moles of the lithium metal oxide.

### Comparative Example 1

A positive electrode active material and a lithium secondary battery were manufactured in the same manner as in Example 1, except that the coating heat treatment step was not performed.

### Comparative Example 2

A positive electrode active material and a lithium secondary battery were manufactured in the same manner as in Example 1, except that in the coating heat treatment step, the added amount of Co(OH)₂ was 0.5 mol% based on the total number of moles of the lithium metal oxide, and the added amount of the second lithium raw material was 2.0 mol% based on the total number of moles of the lithium metal oxide.

### Comparative Example 3

A positive electrode active material and a lithium secondary battery were manufactured in the same manner as in Example 1, except that in the coating heat treatment step, the added amount of Co(OH)₂ was 5.0 mol% based on the total number of moles of the lithium metal oxide, and the added amount of the second lithium raw material was 2.0 mol% based on the total number of moles of the lithium metal oxide.

### Comparative Example 4

A positive electrode active material and a lithium secondary battery were manufactured in the same manner as in Example 1, except that in the coating heat treatment step, the added amount of Co(OH)₂ was 2.0 mol% based on the total number of moles of the lithium metal oxide, the added amount of the second lithium raw material was 2.0 mol% based on the total number of moles of the lithium metal oxide, and the coating heat treatment temperature was 600°C.

### Comparative Example 5

A positive electrode active material and a lithium secondary battery were manufactured in the same manner as in Example 1, except that in the coating heat treatment step, the added amount of Co(OH)₂ was 2.0 mol% based on the total number of moles of the lithium metal oxide, the added amount of the second lithium raw material was 2.0 mol% based on the total number of moles of the lithium metal oxide, and the coating heat treatment temperature was 750°C.

### Comparative Example 6

A positive electrode active material and a lithium secondary battery were manufactured in the same manner as in Example 1, except that in the coating heat treatment step, 2.0 mol% of unground Co(OH)₂ having a sphericity of 0.6 was added based on the total number of moles of the lithium metal oxide, and the added amount of the second lithium raw material was 2.0 mol% based on the total number of moles of the lithium metal oxide.

### Comparative Example 7

A positive electrode active material and a lithium secondary battery were manufactured in the same manner as in Example 1, except that in the coating heat treatment step, the added amount of Co(OH)₂ was 2.0 mol% based on the total number of moles of the lithium metal oxide, and the second lithium raw material was not added.

### Comparative Example 8

A positive electrode active material and a lithium secondary battery were manufactured in the same manner as in Example 1, except that in the coating heat treatment step, the added amount of Co(OH)₂ was 5.0 mol% based on the total number of moles of the lithium metal oxide, and the added amount of the second lithium raw material was 5.0 mol% based on the total number of moles of the lithium metal oxide.

Table 1 below summarizes the above process conditions.

**[Table 1]**

| | Type and properties of cobalt raw material | Cobalt raw material content (Cobalt content in coating layer, mol%) | Coating heat treatment temperature (°C) | Addition of second lithium raw material and added amount |
|---|---|---|---|---|
| Comparati ve Example 1 | None | - | - | - |
| Comparative Example 2 | Co(OH)₂ (grinding), sphericity 0.9 | 0.5 | 680 | w LiOH 2mol% |
| Comparative Example 3 | Co(OH)₂ (grinding), sphericity 0.9 | 5.0 | 680 | w LiOH 2mol% |
| Comparative Example 4 | Co(OH)₂ (grinding), sphericity0.9 | 2.0 | 600 | w LiOH 2mol% |
| Comparati ve Example 5 | Co(OH)₂ (grinding), sphericity 0.9 | 2.0 | 750 | w LiOH 2mol% |
| Comparative Example 6 | Co(OH)₂ (non-grinding), sphericity 0.6 | 2.0 | 680 | w LiOH 2mol% |
| Comparative Example 7 | Co(OH)₂ (grinding), sphericity 0.9 | 2.0 | 680 | w/o LiOH |
| Example 1 | Co(OH)₂ (grinding), sphericity 0.9 | 1.0 | 680 | w LiOH 1mol% |
| Example 2 | Co(OH)₂ (grinding), sphericity 0.9 | 2.0 | 680 | w LiOH 2mol% |
| Comparative Example 8 | Co(OH)₂ (grinding), sphericity 0.9 | 5.0 | 680 | w LiOH 5mol% |

| | | | | |
|---|---|---|---|---|
| (In Table 1, w(with) means the second lithium raw material was added, and w/o(without) means the second lithium raw material was not added.) | | | | |

### Experimental Example 1: Evaluation of Morphology and Crystal Structure of Positive Electrode Active Material

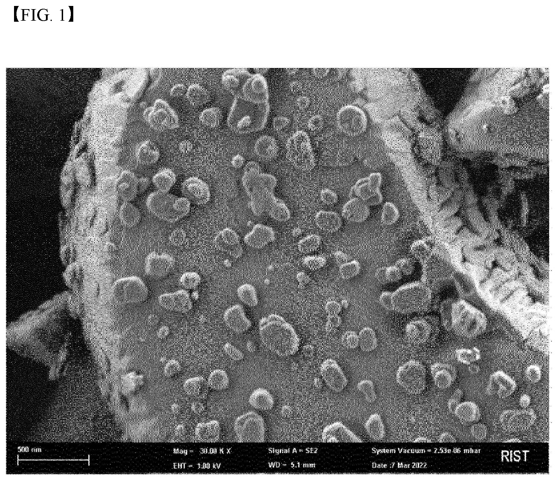

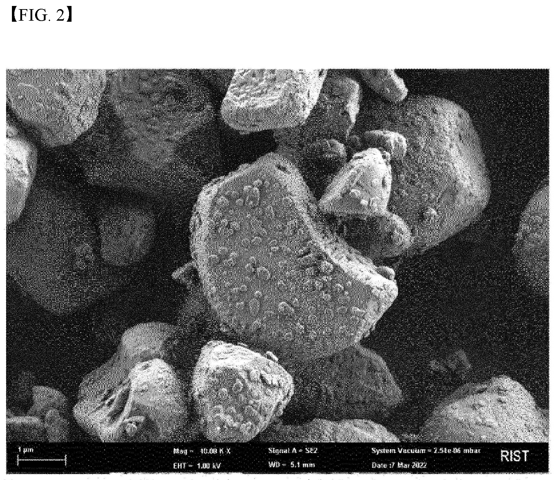

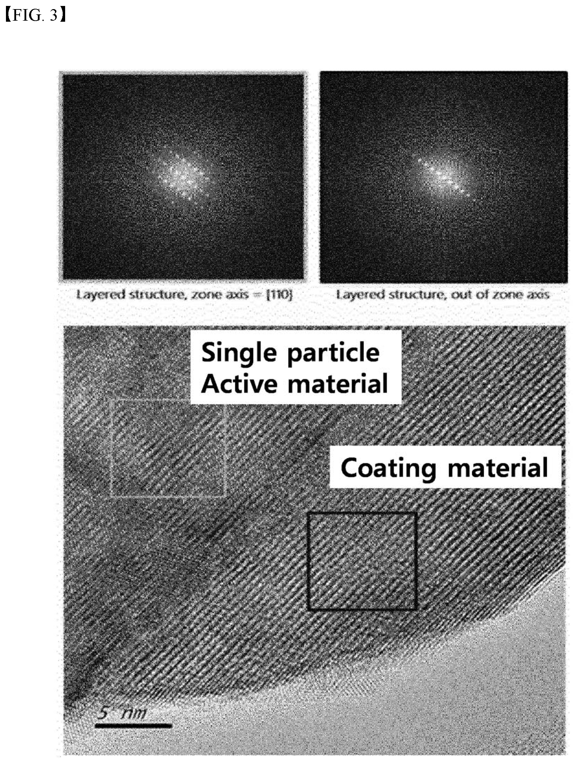

The SEM images of the positive electrode active material prepared according to Example 2 were observed and are shown in FIGS. 1 and 2. In addition, the surface crystal structure was evaluated through TEM and SAED pattern analysis of the positive electrode active material prepared according to Example 2, which is shown in FIG. 3.

Referring to FIGS. 1 and 2, it was confirmed that in the positive electrode active material according to the present invention, an island-type coating layer was formed in which a plurality of dot-shaped attachment particles were attached to the surface of the lithium metal oxide while being spaced apart from each other. In addition, it was confirmed that the average aspect ratio of the plurality of attachment particles was about 1.

Referring to FIG. 3, it was confirmed that in the positive electrode active material according to the present invention, both the lithium metal oxide, which is the bulk portion (core portion), and the coating layer had a layered crystal structure.

### Experimental Example 2: Evaluation of Physical Properties of Positive Electrode Active Material

### (1) Evaluation of Coating Layer Morphology

The morphology of the coating layer (Conformal or Island) was evaluated by observing SEM images for the positive electrode active materials of the Examples and Comparative Examples.

### (2) Evaluation of Average Coverage Rate of Coating Layer

First, the coverage rate of the coating layer for one positive electrode active material particle was obtained as a percentage value of the total area of the attachment particles with respect to the total surface area of the lithium metal oxide particle seen when observing the surface of the lithium metal oxide with a 30,000x magnification SEM. The average coverage rate of the coating layer was evaluated by obtaining the coverage rate for each of 20 arbitrary positive electrode active material particles in the positive electrode active material powder by the above method and calculating their average value.

### (3) Evaluation of Average Thickness of Attachment Particles

First, the thickness of attachment particles for one positive electrode active material particle was derived by obtaining the thickness of an arbitrary attachment particle seen when observing a cross-section of the positive electrode active material particle with a 500,000x magnification TEM. Next, the average thickness of the attachment particles was obtained by deriving the thickness of the attachment particles for each of 20 arbitrary positive electrode active material particles in the positive electrode active material powder by the above method and then deriving their average value.

### (4) Evaluation of Average Diameter of Attachment Particles

The average diameter of the attachment particles was evaluated by calculating the average value of the longest side lengths for 20 arbitrary attachment particles seen when observing the positive electrode active material with a 30,000x magnification SEM.

### (5) Peak Evaluation during X-ray Photoelectron Spectroscopy (XPS) Analysis

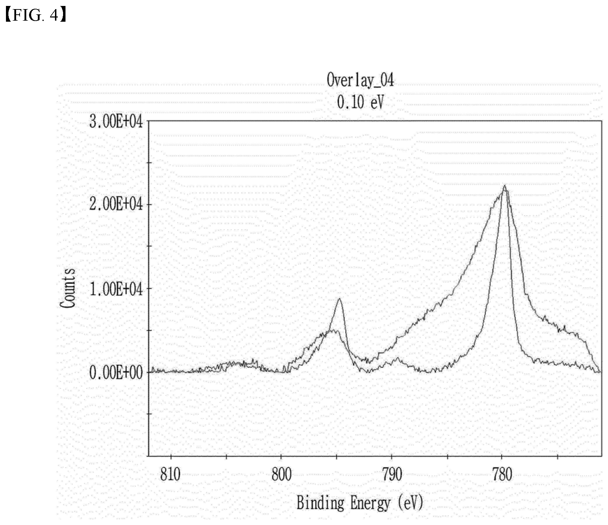

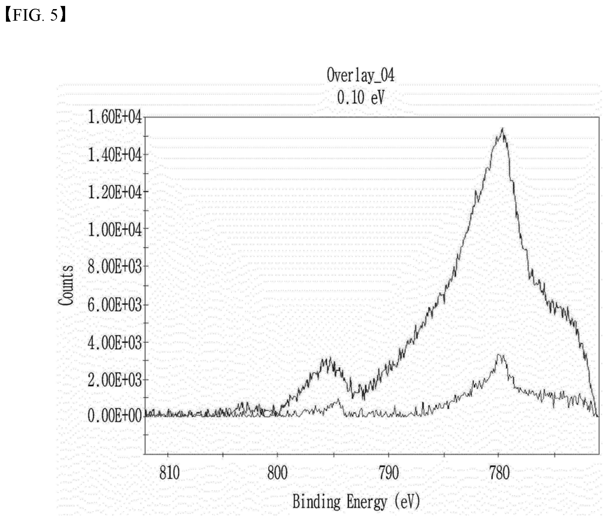

Binding energy peaks (first peak and second peak) at the outermost surface portion of the lithium metal oxide were analyzed through XPS analysis. In addition, binding energy peaks (third peak and fourth peak) at a depth of 100 nm from the outermost surface of the lithium metal oxide were analyzed through the same analysis. FIGS. 4 and 5 show graphs of the analysis results of Example 2 and Comparative Example 1, respectively.

### (6) Evaluation of Residual Lithium

After adding distilled water to the positive electrode active material, residual lithium was extracted using a stirrer, and then the positive electrode active material powder and the extract were separated using a filtering device. Thereafter, the extract was measured through neutralization titration using a Metrohm potentiometric titrator to evaluate residual lithium.

**[Table 2]**

| | Coating layer type | Average thickness of attachment particles (nm) | Average diameter of attachment particles (nm) | Average coverage rate of coating layer (%) | Residual lithium (ppm) |
|---|---|---|---|---|---|
| Comparative Example 1 | - | - | - | - | 7140 |
| Comparative Example 2 | Island | 30 | 100 | 5 | 6615 |
| Comparative Example 3 | Island | 120 | 350 | 50 | 4118 |
| Comparative Example 4 | Island | 60 | 150 | 60 | 5926 |
| Comparative Example 5 | Conformal | 10 | - | 90 | 3289 |
| Comparative Example 6 | Island | 100 | 250 | 30 | 3613 |
| Comparative Example 7 | Island | 100 | 250 | 30 | 4001 |
| Example 1 | Island | 60 | 180 | 40 | 3094 |
| Example 2 | Island | 80 | 200 | 45 | 3128 |
| Comparative Example 8 | Island | 120 | 300 | 55 | 4675 |

**[Table 3]**

| | First peak max height binding energy (eV) | First peak FWHM (eV) | Second peak max height binding energy (eV) | Second peak FWHM (eV) | Third peak max height binding energy (eV) | Third peak FWHM (eV) | Fourth peak max height binding energy (eV) | Fourth peak FWH M (eV) |
|---|---|---|---|---|---|---|---|---|
| Comparative Example 1 | 780.23 | 5.54 | 795.22 | 5.54 | 780.23 | 5.54 | 795.22 | 5.54 |
| Comparative Example 2 | 780.16 | 2.89 | 795.22 | 2.89 | 779.89 | 2.95 | 795.29 | 2.95 |
| Comparative Example 3 | 780.16 | 4.32 | 795.22 | 4.32 | 779.89 | 4.61 | 795.29 | 4.61 |
| Comparativ e Example 4 | 780.16 | 5.23 | 795.22 | 5.23 | 779.89 | 5.55 | 795.29 | 5.55 |
| Comparative Example 5 | 780.18 | 2.57 | 795.23 | 2.57 | 779.89 | 2.78 | 795.29 | 2.78 |
| Comparative Example 6 | 780.16 | 4.33 | 795.22 | 4.33 | 779.89 | 4.45 | 795.29 | 4.45 |
| Comparative Example 7 | 780.16 | 3.87 | 795.22 | 3.87 | 779.89 | 3.98 | 795.29 | 3.98 |
| Example 1 | 780.16 | 2.12 | 795.21 | 2.12 | 779.89 | 2.43 | 795.29 | 2.43 |
| Example 2 | 780.16 | 2.37 | 795.21 | 2.37 | 779.89 | 3.37 | 795.29 | 3.37 |
| Comparative Example 8 | 780.16 | 3.56 | 795.22 | 3.56 | 779.89 | 3.71 | 795.29 | 3.71 |

Referring to Tables 2 and 3, it was confirmed that in the case of Examples in which process conditions including the content of the coating raw material and the coating heat treatment temperature were appropriately controlled, specific structural physical properties of the coating layer, including the average coverage rate of the coating layer, were appropriately obtained within the range according to the present invention. In addition, in the case of the Examples, it was confirmed that the FWHMs of the first to fourth peaks were sufficiently small, so that crystal phases with good electrochemical activity were well formed. Further, in the case of the Examples, it was confirmed that the residual lithium content was significantly reduced. On the other hand, in the case of Comparative Examples 2 and 3 in which the content of the cobalt raw material was too small or too large, it was confirmed that various physical properties, including the average coverage rate of the coating layer, deviated from the range according to the present invention.

In addition, in the case of Comparative Example 4 where the coating heat treatment temperature was too low, it was confirmed that various physical properties, including the average coverage rate of the coating layer, deviated from the range according to the present invention.

In addition, in the case of Comparative Example 5 where the coating heat treatment temperature was too high, it was confirmed that a conformal-type coating layer rather than an island-type was formed.

In addition, in the case of Comparative Example 6 where the sphericity of the cobalt raw material was low, it was confirmed that various physical properties, including the average coverage rate of the coating layer, deviated from the range according to the present invention.

In addition, in the case of Comparative Example 7 where LiOH was not separately added during the coating heat treatment, it was confirmed that various physical properties, including the average coverage rate of the coating layer, deviated from the range according to the present invention.

In addition, in the case of Comparative Example 8 where the added amount of LiOH added during the coating heat treatment was too large, it was confirmed that various physical properties, including the average coverage rate of the coating layer, deviated from the range according to the present invention.

### Experimental Example 3: Evaluation of Electrochemical Characteristics of Lithium Secondary Battery

### (1) Evaluation of Initial Capacity and Initial Efficiency

After manufacturing a lithium secondary battery half cell and aging it at 25°C for 12 hours, a charge/discharge test was performed at 25°C. For the initial capacity evaluation, 200 mAh/g was set as a reference capacity, charging was performed with a constant current of 0.1C to 4.25V, and then switched to constant voltage until the ending current reached 0.05C. After a rest time of 10 minutes after charging, discharging was performed with a constant current of 0.1C, based on the reference capacity of 200 mAh/g, until 2.5V was reached.

### (2) Evaluation of High-Temperature Lifespan Characteristics (45°C, 50 cycles)

After manufacturing a lithium secondary battery half cell, it was charged with a constant current of 0.5C to 4.25V at 45°C and then switched to constant voltage until the ending current reached 0.05C. After a rest time of 10 minutes after charging, discharging was performed with a constant current of 1.0C until 2.5V was reached. Charge and discharge were performed 50 times under these cycle conditions, and the capacity retention rate of the 50th cycle compared to the first cycle was calculated.

### (3) Evaluation of High-Temperature Resistance Increase Rate (45°C, 50 cycles)

After manufacturing a lithium secondary battery half cell, it was charged with a constant current of 0.5C to 4.25V at 45°C and then switched to constant voltage until the ending current reached 0.05C. After a rest time of 10 minutes after charging, discharging was performed with a constant current of 1.0C until 2.5V was reached. Charge and discharge were performed 50 times under these cycle conditions, and the resistance increase rate of the 50th cycle compared to the first cycle was calculated.

**[Table 4]**

| | Initial charge capacity | Initial discharge capacity | Initial efficiency (%) | Lifespan characteristics (%) | Resistance increase rate (%) |
|---|---|---|---|---|---|
| | (mAh/g) | (mAh/g) | | | |
| Comparative Example 1 | 230.4 | 204.6 | 88.8 | 90.1 | 149.6 |
| Comparative Example 2 | 229.5 | 205.2 | 89.6 | 91.5 | 97.3 |
| Comparative Example 3 | 230.5 | 205.2 | 89.7 | 90.5 | 109.4 |
| Comparative Example 4 | 228.8 | 204.3 | 89.5 | 90 | 101.4 |
| Comparative Example 5 | 228.5 | 205.5 | 90.1 | 91.2 | 112.7 |
| Comparative Example 6 | 226.1 | 201.9 | 89.5 | 90.9 | 120.1 |
| Comparative Example 7 | 229.7 | 203.9 | 88.8 | 91 | 106.3 |
| Example 1 | 231.7 | 206.1 | 89 | 90.4 | 100.9 |
| Example 2 | 233.1 | 210.7 | 90.4 | 92 | 97.3 |
| Comparative Example 8 | 230 | 205.6 | 89.4 | 89.8 | 150.4 |

Referring to Table 4, in the case of the Examples in which the coating layer of the positive electrode active material was of the island-type and the specific structure of the coating layer including the average coverage rate satisfied the range according to the present invention, it was confirmed that initial charge capacity and discharge capacity were excellent and the resistance increase rate was very low. On the other hand, in the case of Comparative Example 5 where the coating layer of the positive electrode active material was of the conformal-type, it was confirmed that initial charge capacity and discharge capacity were lower than those of the Examples, and the resistance increase rate was high.

In addition, in the case of Comparative Examples 1 to 4 and 6 to 8 where the coating layer of the positive electrode active material was of the island-type but the specific structural physical properties of the coating layer including the average coverage rate deviated from the range according to the present invention, it was also confirmed that initial charge capacity and discharge capacity were lower than those of the Examples, and the high-temperature resistance increase rate was high. The preferred embodiments of the present invention have been described above, but the present invention is not limited thereto, and it is possible to implement various modifications within the scope of the claims, the detailed description, and the attached drawings, and these also belong to the scope of the present invention. Therefore, the substantial scope of the present invention should be defined by the appended claims and their equivalents.

## Claims

1. A positive electrode active material for a lithium secondary battery, comprising: a single-particle lithium metal oxide; and a coating layer containing cobalt disposed on a surface of the lithium metal oxide, wherein the lithium metal oxide and the coating layer have a layered crystal structure, the coating layer is in an island-type including a plurality of attachment particles that are attached to the surface of the lithium metal oxide and are spaced apart from each other, and an average coverage rate of the coating layer is 35 to 48 area% based on a total surface area of the single particle.

2. The positive electrode active material for a lithium secondary battery of claim 1, wherein an average diameter of the attachment particles is 160 to 240 nm.

3. The positive electrode active material for a lithium secondary battery of claim 1, wherein an average thickness of the attachment particles is 50 to 90 nm.

4. The positive electrode active material for a lithium secondary battery of claim 1, wherein a content of cobalt in the coating layer is 0.7 to 4.8 mol% based on a total number of moles of the lithium metal oxide.

5. The positive electrode active material for a lithium secondary battery of claim 1, wherein in XPS analysis at an outermost surface portion of the lithium metal oxide, a first peak appears in a binding energy region of 775 to 785 eV, and a full width at half maximum (FWHM) of the first peak is 2.5 eV or less.

6. The positive electrode active material for a lithium secondary battery of claim 1, wherein in XPS analysis at the outermost surface portion of the lithium metal oxide, a second peak appears in a binding energy region of 790 to 800 eV, and a full width at half maximum (FWHM) of the second peak is 2.5 eV or less.

7. The positive electrode active material for a lithium secondary battery of claim 1, wherein in XPS analysis at a depth of 100 nm from the outermost surface of the lithium metal oxide, a third peak appears in a binding energy region of 775 to 785 eV, and a full width at half maximum (FWHM) of the third peak is 4 eV or less.

8. The positive electrode active material for a lithium secondary battery of claim 1, wherein in XPS analysis at a depth of 100 nm from the outermost surface of the lithium metal oxide, a fourth peak appears in a binding energy region of 790 to 800 eV, and a full width at half maximum (FWHM) of the fourth peak is 4 eV or less.

9. The positive electrode active material for a lithium secondary battery of claim 1, wherein the coating layer comprises CoO, Co₃O₄, LiCoO₂, or a combination thereof.

10. The positive electrode active material for a lithium secondary battery of claim 1, wherein an average aspect ratio of the attachment particles is 1.5 or less.

11. The positive electrode active material for a lithium secondary battery of claim 1, wherein a residual lithium content is 5,000 ppm or less.

12. The positive electrode active material for a lithium secondary battery of claim 1, wherein the lithium metal oxide is represented by Chemical Formula 1 below:
[Chemical Formula 1] Liₐ[NiₓCo_{y}Mn_{z}M_{w}]O₂
wherein, in Chemical Formula 1, 0.8≤a≤1.3, 0.15≤x≤1, 0≤y≤1, 0≤z≤1, 0≤w≤0.1, x+y+z+w≤1, and M is Zr, Al, B, Y, Mg, Ti, Nb, W, Sc, Si, V, Fe, Y, Mo, Ce, Hf, Ta, La, Sr, Re, Cr, Ga, Pt, or a combination thereof.

13. A method for preparing a positive electrode active material for a lithium secondary battery, the method comprising: preparing a metal precursor; mixing the metal precursor with a first lithium raw material and then calcining the mixture to form a single-particle lithium metal oxide; and mixing the lithium metal oxide with a cobalt raw material and then performing a coating heat treatment to form a cobalt-containing coating layer, wherein the coating layer is in an island-type including a plurality of attachment particles that are attached to a surface of the lithium metal oxide and are spaced apart from each other, and an average coverage rate of the coating layer is 35 to 48 area% based on a total surface area of the single particle.

14. The method of claim 13, wherein in the forming of the coating layer, the cobalt raw material is added in an amount of 0.7 to 4.8 mol% based on a total number of moles of the lithium metal oxide.

15. The method of claim 13, wherein in the forming of the coating layer, the coating heat treatment is performed at a temperature of 620 to 700°C.

16. The method of claim 13, wherein the cobalt raw material has a sphericity of 0.8 or more.

17. The method of claim 13, wherein in the forming of the coating layer, a second lithium raw material is further mixed.

18. The method of claim 17, wherein an added amount of the second lithium raw material is 4 mol% or less based on the total number of moles of the lithium metal oxide.

19. The method of claim 13, wherein the cobalt raw material is Co(OH)₂, CoCl₂, CoO, CoF₃, CoSO₄·xH₂O, CoSO₄·7H₂O, (CH₃COO)₂Co·4H₂O, Co(NO₃)₂·6H₂O, (CH₃CO₂)₂Co, CoCO₃·xH₂O, Co₃(PO₄)₂, or a combination thereof.

20. The method of claim 13, wherein a water washing process is not performed after the forming of the lithium metal oxide and before the forming of the coating layer.

21. A positive electrode for a lithium secondary battery comprising the positive electrode active material of claim 1.

22. A lithium secondary battery comprising the positive electrode for a lithium secondary battery of claim 21.
